(19) Europäisches Patentamt / European Patent Office / Office européen des brevets

(11) **EP 4 167 272 B1**

(12) **EUROPEAN PATENT SPECIFICATION**

(45) Date of publication and mention
of the grant of the patent:
**18.06.2025  Bulletin 2025/25**

(21) Application number: **20956657.9**

(22) Date of filing: **05.10.2020**

(51) International Patent Classification (IPC):
***H01L 21/3065*** *(2006.01)*      *H01J 37/32* *(2006.01)*

(52) Cooperative Patent Classification (CPC):
**H01L 21/30655; H01J 37/32449**

(86) International application number:
**PCT/JP2020/037709**

(87) International publication number:
**WO 2022/074708 (14.04.2022 Gazette 2022/15)**

(54) **PLASMA PROCESSING METHOD**

PLASMAVERARBEITUNGSVERFAHREN

PROCÉDÉ DE TRAITEMENT PAR PLASMA

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**19.04.2023  Bulletin 2023/16**

(73) Proprietor: **SPP Technologies Co., Ltd.
Tokyo 100-0003 (JP)**

(72) Inventors:
• **SUEDA, Kazuyuki
  Amagasaki-shi, Hyogo 660-0891 (JP)**
• **SASAKURA, Masahiro
  Amagasaki-shi, Hyogo 660-0891 (JP)**

• **YAMAMOTO, Ryoto
  Amagasaki-shi, Hyogo 660-0891 (JP)**
• **SUMIKAWA, Mai
  Amagasaki-shi, Hyogo 660-0891 (JP)**

(74) Representative: **Wynne-Jones IP Limited
Southgate House
Southgate Street
Gloucester, Gloucestershire GL1 1UB (GB)**

(56) References cited:
JP-A- 2011 124 239      JP-A- 2011 124 239
JP-A- 2012 238 891      JP-A- 2016 171 323
JP-A- 2017 085 083      JP-A- 2017 518 645
JP-A- 2017 518 645      JP-A- 2018 137 266
JP-B2- 6 438 511

## Description

[Technical Field]

The present invention relates to a plasma processing method. In particular, the present invention relates to a plasma processing method, with which impacts on global warming can be suppressed and high-throughput plasma processing can be achieved.

[Background Art]

Traditionally, as a way of being able to perform high-aspect ratio etching on a substrate (wafer) made of Si or the like, deep etching, which is referred to as Bosch processing, has been used (for example, see Patent Literature 1).

The deep etching is a plasma processing method for high-aspect ratio etching of a substrate by executing alternately and repeatedly an etching process of etching the substrate by using plasma of an etching gas such as $SF_6$, and a protective film deposition process of depositing a protective film in a recess formed through the etching process by using plasma of a protective film deposition gas such as $c\text{-}C_4F_8$ (hereinafter referred to simply as "$C_4F_8$" in the specification and claims).

$C_4F_8$, which is generally used as a protective film deposition gas for deep etching, suffers from a problem of exacerbating the global warming when used in a large quantity because the global warming potential thereof is as high as 9540 (as described in IPCC (Intergovernmental Panel on Climate Change) Fifth Assessment Report: impacts on global warming for 100 years when $CO_2$ is defined as 1).

Therefore, instead of $C_4F_8$, it has been proposed to use 2,3,3,3-tetrafluoropropene (also referred to as HFO-1234yf, chemical formula: CF3-CF=CH2), which has the global warming potential of as small as less than 1 (as described in IPCC Fifth Assessment Report; impacts on global warming for 100 years when $CO_2$ is defined as 1), as a protective film deposition gas for deep etching (for example, see Patent Literature 2).

However, it has been found that when 2,3,3,3-tetrafluoropropene is used as a protective film deposition gas for deep etching, a large amount of CF polymer, which is a film composition, is deposited in a chamber of a plasma processing apparatus in the protective film deposition process of the deep etching. Such contamination caused by the CF polymer in the chamber may degrade a process stability for substrates within a lot or between lots.

Consequently, a problem is that when a plurality of substrates are subjected to deep etching, extensive time is required for a cleaning process in the chamber, which is performed by using plasma of a cleaning gas such as $O_2$, after completion of the deep etching on one substrate and before starting of the deep etching on the next substrate, resulting in a decrease in throughput.

JP 2016 171323 A discloses a wiring board manufacturing method in which a protective film forming gas is used which can be, for example, a fluorocarbon gas and/or 2,3,3,3-tetrafluoropropene. JP 2011 124239 A discloses a dry etching gas and an associated dry etching method. The dry etching gas comprises 2,3,3,3-tetrafluoropropene which can be in combination with a wide variety of other constituents, including $C_4F_8$.

[Citation List]

[Patent Literature]

    [Patent Literature 1] JP6529943B
    [Patent Literature 2] JP6438511B

[Summary of Invention]

[Technical Problem]

An object of the present invention, which has been made to solve the problem of the above-described related art, is to provide a plasma processing method, with which impacts on global warming can be suppressed and high-throughput plasma processing can be achieved.

[Solution to Problem]

In order to solve the above-described problem, as a result of diligent study, the present inventors have found that a mixed gas of $C_4F_8$ and 2,3,3,3-tetrafluoropropene may be used as a protective film deposition gas for deep etching, and have completed the present invention, which is as defined in appended claims 1 to 3.

That is, in order to solve the above-described problem, the present invention provides a plasma processing method of subjecting a substrate to deep etching, using a processing gas, wherein the plasma processing gas is a mixed gas of $C_4F_8$ and 2,3,3,3-tetrafluoropropene.

By using the plasma processing gas as a protective film deposition gas for deep etching, impacts on global warming can be suppressed as compared to the case of using $C_4F_8$ as a protective film deposition gas. Further, as a result of a reduction in time required for cleaning process, high-throughput plasma processing can be achieved as compared to the case of using 2,3,3,3-tetrafluoropropene as a protective film deposition gas.

The flow rate ratio of 2,3,3,3-tetrafluoropropene in the mixed gas is 5% or more and 60% or less.

In the preferable configuration described above, the flow rate ratio of 2,3,3,3-tetrafluoropropene in the mixed gas refers to a flow rate (volume flow rate) of 2,3,3,3-tetrafluoropropene / a flow rate (volume flow rate) of the mixed gas. In a state in which no plasma processing gas (mixed gas) flows, the flow rate ratio in the preferable configuration described above refers to a volume ratio (volume of 2,3,3,3-tetrafluoropropene / volume of mixed gas).

According to the preferable configuration described above, high-throughput plasma processing can be achieved, the throughput being equivalent to, or higher, as compared not only to the case of using 2,3,3,3-tetrafluoropropene as a protective film deposition gas, but also to the case of using $C_4F_8$.

More preferably, the flow rate ratio of 2,3,3,3-tetrafluoropropene in the mixed gas is 5% or more and 45% or less. According to the more preferable configuration, higher throughput plasma processing can be achieved than the case of using $C_4F_8$ as a protective film deposition gas.

Preferably, the flow rate ratio of 2,3,3,3-tetrafluoropropene in the mixed gas is 20% or more and 60% or less.

According to the preferable configuration described above, gas usage required for obtaining a predetermined etching depth can be more reduced as compared to the case of using $C_4F_8$ as a protective film deposition gas.

Accordingly, in the present invention, the flow rate ratio of 2,3,3,3-tetrafluoropropene in the mixed gas can be 20% or more and 60% or less (more preferably, 20% or more and 45% or less) to achieve plasma processing with which impacts on global warming are suppressed, the throughput is high, and the gas usage is small.

According to the invention, the plasma processing gas is used in a protective film deposition process for deep etching of a substrate.

In order to solve the above-described problem, the present invention provides a plasma processing method as defined in claims 1 to 3 of subjecting a substrate to deep etching by executing alternately and repeatedly an etching process of etching the substrate by using plasma generated in a chamber and a protective film deposition process of depositing a protective film in a recess formed through the etching process by using plasma generated in a chamber, wherein in the protective film deposition process, a plasma processing gas which is a mixed gas of $C_4F_8$ and 2,3,3,3-tetrafluoropropene and a flow rate ratio of 2,3,3,3-tetrafluoropropene in the mixed gas is set to 5% or more and 60% or less is used as gas supplied for generating plasma and wherein after completion of the deep etching on the substrate, a cleaning process step is executed to clean the chamber.

Note that in each of protective film deposition processes that are executed repeatedly, the flow rate ratio of 2,3,3,3-tetrafluoropropene in the plasma processing gas (mixed gas) is not necessarily constant, and a different flow rate ratio may be set for each of the protective film deposition processes. Further, the flow rate ratio may be changed during one protective film deposition process.

Further, a plasma processing apparatus is also provided, the plasma processing apparatus including a chamber in which plasma is generated, a mounting table disposed in the chamber, wherein a substrate is mounted on the mounting table, and a gas supply source for supplying gas for generating plasma in the chamber, wherein the substrate is subjected to deep etching by executing alternately and repeatedly an etching process of etching the substrate by using plasma and a protective film deposition process of depositing a protective film in a recess formed through the etching process by using plasma, and wherein in the protective film deposition process, the plasma processing gas is supplied from the gas supply source into the chamber as gas supplied for generating plasma.

[Advantageous Effects of Invention]

According to the present invention, impacts on global warming can be suppressed and high-throughput plasma processing can be achieved.

[Brief Description of Drawings]

Fig. 1 is a partial sectional view diagrammatically illustrating a schematic configuration of a plasma processing apparatus.
Fig. 2 is a flow chart illustrating a schematic procedure of plasma processing method according to an embodiment of the present invention.
Figs. 3A, 3B, and 3C are SEM photographs illustrating example shapes of trenches formed by deep etching.
Fig. 4 is a graph for describing how to determine cleaning time in the cleaning process S6 illustrated in Fig. 2.
Fig. 5 illustrates primary test conditions and test results of Examples 1-1 to 1-4 and Comparative Examples 1-5, 1-6, 1-1, 1-2.
Figs. 6A and 6B are SEM photographs illustrating example shapes of holes formed by deep etching.
Fig. 7 illustrates primary test conditions and test results of Examples 2-1 to 2-4 and Comparative Examples 2-5, 2-6, 2-1, 2-2.
Figs. 8A, 8B, and 8C illustrate, based on test results of Examples 1-1 to 1 - 4 and 2 - 1 to 2 - 4 and Comparative Examples 1-5, 1-6, 1-1, 1-2, 2-5, 2-6, 2-1, 2-2 of a relationship between the flow rate ratio of HFO-1234yf and throughput, a relationship between the flow rate ratio of HFO-1234yf and a total gas usage and a relationship between the flow rate ratio of HFO-1234yf and $CO_2$ equivalent emissions in an ordered manner.

[Description of Embodiments]

An embodiment of the present invention will now be described with reference to drawings as required.

For convenience in the description, the dimensions and the scale of each component illustrated in each drawing may be different from actual ones.

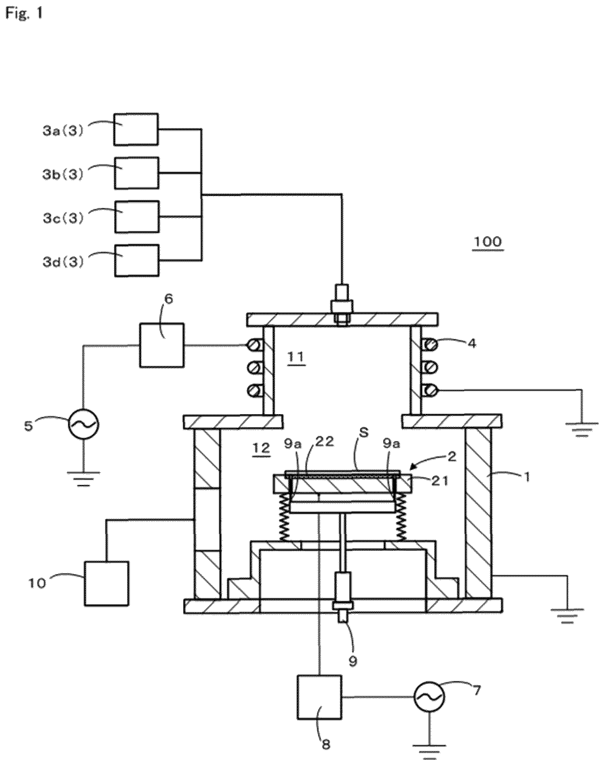

Fig. 1 is a partial sectional view diagrammatically illustrating a schematic configuration of a plasma processing apparatus.

As illustrated in Fig. 1, a plasma processing apparatus 100 includes a chamber 1, a mounting table 2, and a gas supply source 3. The plasma processing apparatus 100 also includes a coil 4, high frequency power supplies 5, 7, impedance matching devices 6, 8, a lifting device 9, lift pins 9a, and an exhaust device 10.

In the chamber 1, a plasma generation space 11 in which plasma is generated is provided in the upper part, and a plasma processing space 12 in which plasma processing is to be executed is provided in the lower part.

The coil 4 is disposed outside the chamber 1, surrounding the plasma generation space 11.

The mounting table 2 is disposed in the plasma processing space 12, and a substrate S to be subjected to plasma processing is mounted on the mounting table 2. The mounting table 2 may be attached to a lifting means (not illustrated) for moving up and down the mounting table 2, or may be fixed to the chamber 1 in a non-liftable manner. The mounting table 2 includes a mounting table body (obliquely hatched portion) 21 formed of metal such as Al, and an electrostatic chuck (dotted hatched portion) 22 located on the mounting table body 21 and formed of a dielectric in which an electrode (not illustrated) is embedded. A DC power supply (not illustrated) is connected to the electrostatic chuck 22, and an electrostatic force between the electrode and a substrate S generated by applying a DC voltage from the DC power supply to the electrode of the electrostatic chuck 22 causes the electrostatic chuck 22 to attract the substrate S while plasma processing is being executed.

The mounting table 2 is provided with an inner piping (not illustrated), and a chiller device (not illustrated) is attached thereto for introducing a predetermined refrigerant such as Galden (registered trademark) into the inner piping and circulating the refrigerant while controlling temperature of the refrigerant (controlled at, for example, 5°C). In this way, the substrate S is cooled while plasma processing is being executed. Further, while plasma processing is being executed, a heat-transfer gas (inert gas such as He gas) is supplied from a predetermined heat-transfer gas supply pipe (not illustrated) to a back surface of the substrate S so that the substrate S is cooled.

The gas supply source 3 supplies a plasma processing gas to the plasma generation space 11. The plasma processing apparatus 100 includes gas supply sources 3a, 3b, 3c, and 3d as the gas supply source 3.

The gas supply source 3a supplies $SF_6$ as an etching gas. The gas supply source 3b supplies $C_4F_8$ as a protective film deposition gas. The gas supply source 3c supplies 2,3,3,3-tetrafluoropropene (hereinafter referred to as HFO-1234yf) as a protective film deposition gas. The gas supply source 3d supplies $O_2$ as a cleaning gas.

The high frequency power supply 5 applies high frequency power to the coil 4 through the impedance matching device 6. The high frequency power supply 7 applies high frequency power to the mounting table body 21 of the mounting table 2 through the impedance matching device 8.

The lift pins 9a are attached to the lifting device 9 and can move up and down with respect to holes through the mounting table 2. The substrate S to be subjected to plasma processing is transported from the outside of the chamber 1 into the chamber 1 by a transport mechanism (not illustrated), and mounted on the lift pins 9a projecting above the top face (the top face of the electrostatic chuck 22) of the mounting table 2. Next, the lift pins 9a are lowered by the lifting device 9, and thereby the substrate S is mounted on the mounting table 2 (the electrostatic chuck 22). Once the plasma processing is completed, the substrate S is electrically neutralized, and thereafter the lift pins 9a are raised by the lifting device 9, and the substrate S is raised accordingly. The raised substrate S is to be transported to the outside of the chamber 1 by the transport mechanism.

The exhaust device 10 exhausts gas in the chamber 1 (the plasma generation space 11 and the processing space 12) to the outside of the chamber 1.

The plasma processing method according to the embodiment is executed by using the plasma processing apparatus 100 configured as described above. The plasma processing method according to the embodiment will now be described.

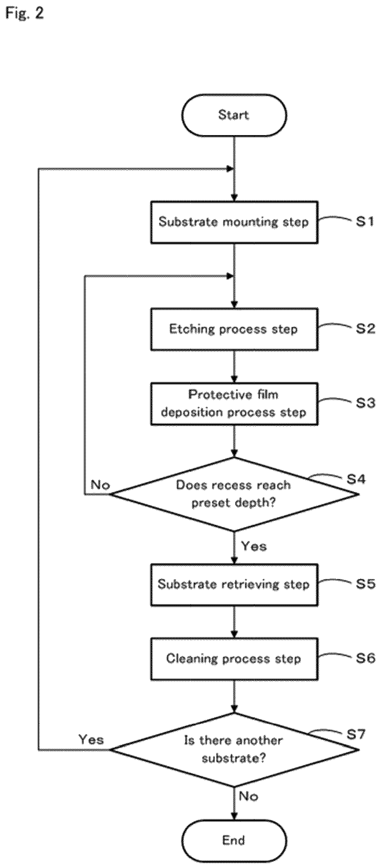

Fig. 2 is a flow chart illustrating a schematic procedure of the plasma processing method according to the embodiment. As illustrated in Fig. 2, the plasma processing method according to the embodiment includes an etching process step S2 and a protective film deposition process step S3. The plasma processing method according to the embodiment also includes a substrate mounting step S1, a substrate retrieving step S5, and a cleaning process step S6.

In the substrate mounting step S1, the substrate S to be subjected to plasma processing is transported from the outside of the chamber 1 into the chamber 1, and mounted on the mounting table 2. On the substrate S, there is disposed a mask (not illustrated) provided with patterns that correspond to desired shapes and dimensions. The mask is formed from, for example, photoresist.

In the etching process step S2, the substrate S is subjected to an etching process. Specifically, after the inside of the chamber 1 is placed into a decompressed state by the exhaust device 10, $SF_6$ is supplied from the gas supply source 3a to the plasma generation space 11 as an etching gas, and high frequency power is applied from the high frequency power supplies 5, 7 to the coil 4 and the mounting table 2. The application of the high frequency power to the coil 4 turns $SF_6$ into plasma. On the other hand, the application of high frequency power to the mounting table 2 causes a potential difference between the mounting table 2 and plasma, and due to the potential difference, ions in the plasma move toward the mounting table 2. The ions in the plasma impinge on the substrate S through the mask, so that the substrate S is etched. In the etching process step S2 after the protective film deposition process step S3 described later is executed (i.e. a second and subsequent etching process step S2), a protective film deposited on a bottom surface of the recess is removed, and thereafter the substrate S is to be etched.

Next, in the protective film deposition process step S3, the substrate S is subjected to a protective film deposition process. Specifically, $C_4F_8$ and HFO-1234yf are supplied from the gas supply sources 3b, 3c, respectively, to the plasma generation space 11 as a protective film deposition gas simultaneously, and high frequency power is applied from the high frequency power supply 5 to the coil 4. In other words, a mixed gas of $C_4F_8$ and HFO-1234yf is supplied as a protective film deposition gas. The flow rate ratio of HFO-1234yf in the mixed gas (the flow rate of HFO-1234yf / the flow rate of mixed gas) can be set by adjusting the flow rate of $C_4F_8$ supplied from the gas supply source 3b and the flow rate of HFO-1234yf supplied from the gas supply source 3c. For example, to make the flow rate ratio of HFO-1234yf in the mixed gas 50%, the flow rate of $C_4F_8$ supplied from the gas supply source 3b and the flow rate of HFO-1234yf supplied from the gas supply source 3c may be adjusted to the same degree.

The application of high frequency power to the coil 4 turns the mixed gas for the protective film deposition process into plasma. The generated plasma moves toward the mounting table 2 and is deposited in the recess of the substrate S formed through an etching process, so that a protective film is deposited in the recess of the substrate S.

In the embodiment, although the etching process step S2 is executed first and thereafter the protective film deposition process step S3 is executed, this is not a limitation, and it may be possible to execute the etching process step S2 after the protective film deposition process step S3 is executed first.

In the plasma processing method according to the embodiment, the etching process step S2 and the protective film deposition process step S3 described above are repeated alternately until the recess reaches a preset depth (until "Yes" in S4 in Fig. 2). In other words, if "No" in S4 in Fig. 2, the etching process step S2 and the protective film deposition process step S3 are executed again. Whether the recess reaches a preset depth or not can be determined by, for example, experimentally examining an etched depth in one etching process step S2 (advancement of depth of the recess to be formed) in advance, determining the number of times of etching process steps S2 required for reaching the preset depth in advance, and determining whether or not the number of times is reached. The etched depth in one etching process step S2 can be determined by, for example, examining an etched depth in a plurality of times of etching process steps S2 and dividing the etched depth by the number of times of the etching process steps S2.

As described above, in the plasma processing method according to the embodiment, since Bosch processing that repeats alternately the etching process step S2 and the protective film deposition process step S3 is applied, the substrate S can be subjected to deep etching.

Fig. 2 illustrates a flow of repeating alternately the etching process step S2 and the protective film deposition process step S3 and finally executing the protective film deposition process step S3 to complete the deep etching. However, the present invention is not limited thereto, and it is possible to adopt a flow of finally executing the etching process step S2 to complete the deep etching.

In the plasma processing method according to the embodiment, the deep etching of the substrate S is completed ("Yes" in S4 in Fig. 2), the substrate S is electrically neutralized and thereafter retrieved by transporting the substrate from the inside to the outside of the chamber 1 in the substrate retrieving step S5. Thereafter, the cleaning process step S6 of subjecting the chamber 1 to a cleaning process is executed. In the case in which deep etching is to be executed at a plurality of locations in one substrate S at different timing, the cleaning process step S6 is to be executed after completion of the deep etching in all locations.

In the embodiment, the cleaning process step S6 is executed every time one substrate S is subjected to deep etching and retrieved, which is preferable in terms of process stability. However, this is not a limitation, and the cleaning process step S6 may be executed every time a plurality of substrates S are subjected to deep etching and retrieved (for example, between lots of the substrates S).

In the cleaning process step S6, after the inside of the chamber 1 is placed into a decompressed state by the exhaust device 10, $O_2$ is supplied from the gas supply source 3d to the plasma generation space 11 as a cleaning gas, and high frequency power is applied from the high frequency power supply 5 to the coil 4. The application of high frequency power to the coil 4 turns $O_2$ into plasma. O-radicals contained in the generated plasma react with CF polymer, which is a film composition, attached to the chamber 1, so that the CF polymer is removed and discharged to the outside of the chamber 1 by the exhaust device 10.

In the plasma processing method according to the embodiment, when another substrate S is to be subjected to deep etching after the cleaning process step S6 described above is executed ("Yes" in S7 in Fig. 2), the substrate mounting step S1 to the substrate retrieving step S6 are executed on the other substrate S.

According to the plasma processing method according to the embodiment described above, a mixed gas of $C_4F_8$ and HFO-1234yf is used as a protective film deposition gas in the protective film deposition process step S3. Accordingly, impacts on global warming can be suppressed as compared to the case of using $C_4F_8$ as a protective film deposition gas. Further, as a result of a reduction in time required for cleaning process, high-throughput plasma processing can be achieved as compared to the case of using HFO-1234yf as a protective film deposition gas.

In the embodiment, $C_4F_8$ is supplied from the gas supply source 3b to the plasma generation space 11, and HFO-1234yf is supplied from the gas supply source 3c to the plasma generation space 11. In other words, in the embodiment, description has been made to a manner in which $C_4F_8$ and HFO-1234yf are supplied from different gas supply sources respectively and mixed in the plasma generation space 11. However, the present invention is not limited thereto, and it is possible to adopt a manner in which a mixed gas of $C_4F_8$ and HFO-1234yf, which have been previously mixed in a single gas supply source at a predetermined flow rate ratio (volume ratio), is supplied to the plasma generation space 11.

In the embodiment, $C_4F_8$ and HFO-1234yf are supplied simultaneously as a protective film deposition gas in the protective film deposition process step S3. However, provided that $C_4F_8$ and HFO-1234yf are sufficiently mixed in the chamber 1, timing of supplying $C_4F_8$ and HFO-1234yf is not necessarily simultaneous in a strict sense, and it is possible to adopt a manner in which they are supplied with a small time difference (time difference of, for example, on the order of milliseconds).

An example of test results of the plasma processing method according to the embodiment and plasma processing methods according to comparative examples will now be described.

<Example 1-1>

With the plasma processing apparatus 100 illustrated in Fig. 1, a test was performed to form a trench having a width of 30 $\mu$m and a depth of 250 $\mu$m in a substrate S (Si substrate) by deep etching.

In the etching process step S2, conditions were as follows: etching step time (time required for one etching process) was 14.0 sec, the flow rate of supplied $SF_6$ was 600 sccm, the pressure in the chamber 1 was 25 Pa, the high frequency power applied to the coil 4 was 4500 W, and the high frequency power applied to the mounting table body 21 of the mounting table 2 was 40 W.

In the protective film deposition process step S3, conditions were as follows: protective film deposition step time (time required for one protective film deposition process) was 2.2 sec, the flow rate of supplied mixed gas was 450 sccm, the pressure in the chamber 1 was 20 Pa, and the high frequency power applied to the coil 4 was 3000 W. The condition of the flow rate ratio of HFO-1234yf in the mixed gas was 5%.

Under the above-described conditions, the etching process step S2 and the protective film deposition process step S3 were alternately and repeatedly executed until a trench having a depth of 250 $\mu$m was formed.

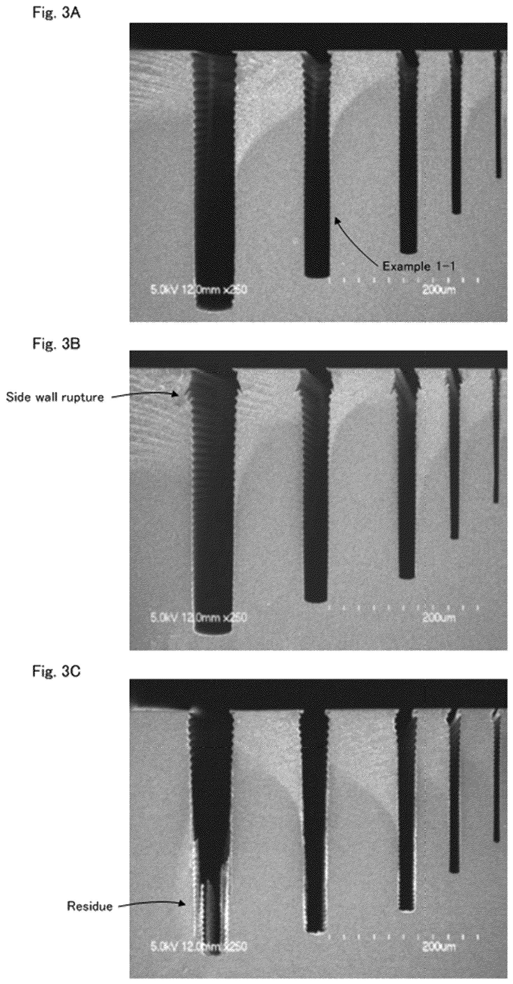

Figs. 3A, 3B, and 3C are sectional SEM photographs illustrating example shapes of trenches formed by deep etching. Fig. 3A illustrates an example shape of a trench in good shape, Fig. 3B illustrates an example shape of a trench suffering from a side wall rupture, and Fig. 3C illustrates an example shape of a trench with a residue. Note that the second trench from the left of Fig. 3A corresponds to a trench formed in Example 1-1.

When the protective film deposition step time set in the protective film deposition process step S3 is too short, the thickness of the protective film deposited on a side wall of a trench (in particular, upper side wall) is reduced. As a result, in the etching process step S2, the side wall of the trench is etched due to an insufficient thickness of the protective film, leading to a side wall rupture as illustrated in Fig. 3B. On the other hand, when the protective film deposition step time set in the protective film deposition process step S3 is too long, the thickness of the protective film deposited on a bottom surface of the trench is increased. As a result, in the etching process step S2, the protective film deposited on the bottom surface of the trench is not sufficiently removed, leading to a residue as illustrated in Fig. 3C. Accordingly, the protective film deposition step time set in the protective film deposition process step S3 was set to the shortest time without causing a side wall rupture.

In the cleaning process step S6, cleaning was executed for the cleaning time of 138.0 sec under the following conditions: the flow rate of supplied $O_2$ was 300 sccm, the pressure in the chamber 1 was 1 Pa, and the high frequency power applied to the coil 4 was 2500 W.

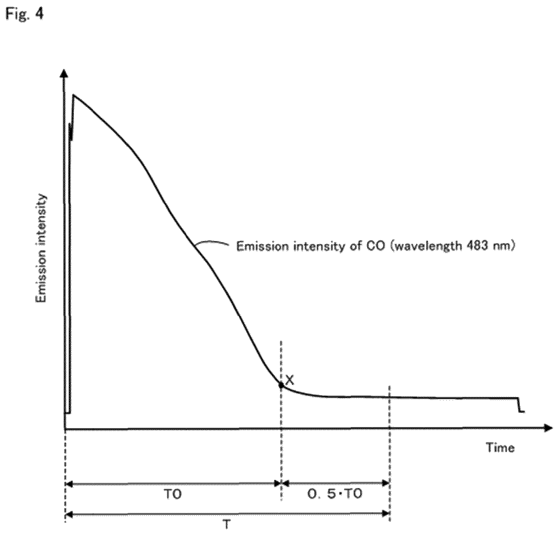

Fig. 4 is a graph for describing how to determine cleaning time.

Specifically, a known emission spectrophotometer (Optical Emission Spectrometer) was attached to the plasma processing apparatus 100 and the emission intensity of CO (wavelength 483 nm), which was a reaction product of CF polymer, which was a film composition, and $O_2$, was measured. Fig. 4 diagrammatically illustrates a change in the emission intensity of CO from the start of execution of the cleaning process step S6.

As illustrated in Fig. 4, a point at which an absolute value of the rate of change of the emission intensity of CO reaches 1% or less is defined as an end point X. The rate of change of the emission intensity refers to (emission intensity at current measurement time - emission intensity at previous measurement time) / emission intensity at previous measurement time × 100 [%]. When the elapsed time from the start of execution of the cleaning process step S6 to the end point X is defined as T0, the cleaning time T = T0 + 0.5 • T0 = 1.5T0. In other words, 50% overcleaning was executed.

The etching process step S2 and the protective film deposition process step S3 described above are repeatedly executed on one substrate S, thereafter the chamber 1 is subjected to the cleaning process step S6, and then the result of evaluation of throughput was 4.62 wph. The unit "wph" is an abbreviation of "wafers per hour" and refers to the number of substrates S processed per 1 hour.

In the evaluation of throughput, time spent for executing the substrate mounting step S1 and the substrate retrieving step S5 is included.

In Example 1-1, although one substrate S was used to evaluate throughput, it is possible to evaluate time spent for performing a series of steps of the substrate mounting step S1 to the cleaning process step S6 for each of a plurality of substrates S, and evaluate the throughput from an average. Same applies to other Examples 1-2 to 1-4 and Comparative Examples 1-5, 1-6, 1-1, 1-2 described later.

<Example 1-2>

Except that the flow rate ratio of HFO-1234yf in the mixed gas used in the protective film deposition process step S3 was 20%, a trench was formed by executing deep etching under the same conditions as in Example 1-1 (setting of the protective film deposition step time and determination of the cleaning time were made in a similar way, although values may be different). The throughput was 4.72 wph.

<Example 1-3>

Except that the flow rate ratio of HFO-1234yf in the mixed gas used in the protective film deposition process step S3 was 45%, a trench was formed by executing deep etching under the same conditions as in Example 1-1 (setting of the protective film deposition step time and determination of the cleaning time were made in a similar way, although values may be different). The throughput was 4.64 wph.

<Example 1-4>

Except that the flow rate ratio of HFO-1234yf in the mixed gas used in the protective film deposition process step S3 was 50%, a trench was formed by executing deep etching under the same conditions as in Example 1-1 (setting of the protective film deposition step time and determination of the cleaning time were made in a similar way, although values may be different). The throughput was 4.60 wph.

<Comparative Example 1-5>

Except that the flow rate ratio of HFO-1234yf in the mixed gas used in the protective film deposition process step S3 was 80%, a trench was formed by executing deep etching under the same conditions as in Example 1-1 (setting of the protective film deposition step time and determination of the cleaning time were made in a similar way, although values may be different). The throughput was 4.21 wph.

<Comparative Example 1-6>

Except that the flow rate ratio of HFO-1234yf in the mixed gas used in the protective film deposition process step S3 was 95%, a trench was formed by executing deep etching under the same conditions as in Example 1-1 (setting of the protective film deposition step time and determination of the cleaning time were made in a similar way, although values may be different). The throughput was 3.96 wph.

<Comparative Example 1-1>

Except that the protective film deposition gas used in the protective film deposition process step S3 was $C_4F_8$ alone (in other words, the flow rate ratio of HFO-1234yf was 0%), a trench was formed by executing deep etching under the same conditions as in Example 1-1 (setting of the protective film deposition step time and determination of the cleaning time were made in a similar way, although values may be different). The throughput was 4.62 wph.

<Comparative Example 1-2>

Except that the protective film deposition gas used in the protective film deposition process step S3 was HFO-1234yf alone (in other words, the flow rate ratio of HFO-1234yf was 100%), a trench was formed by executing deep etching under the same conditions as in Example 1-1 (setting of the protective film deposition step time and determination of the cleaning time were made in a similar way, although values may be different). The throughput was 3.95 wph.

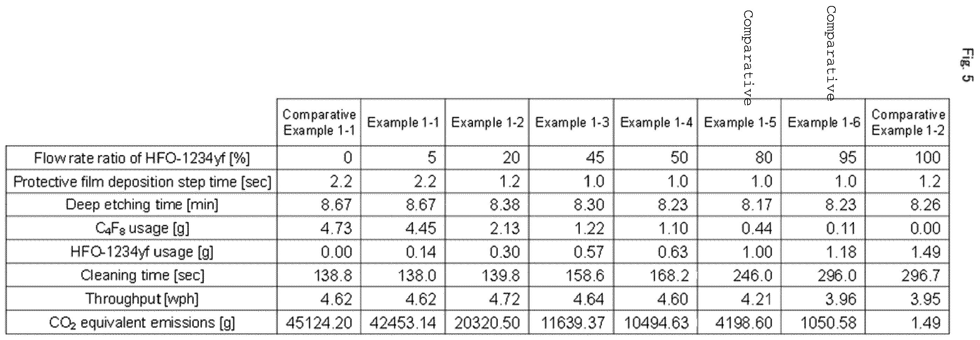

Fig. 5 illustrates primary test conditions and test results of Examples 1-1 to 1-4 and Comparative Examples 1-5, 1-6, 1-1, 1-2 as described above.

"Deep etching time" illustrated in Fig. 5 refers to time spent for forming a trench having a depth of 250 $\mu$m. "$C_4F_8$ usage" refers to a total usage of $C_4F_8$ used for forming the trench having a depth of 250 $\mu$m. "HFO-1234yf usage" refers to a total usage of HFO-1234yf used for forming the trench having a depth of 250 $\mu$m. "$CO_2$ equivalent emissions" refer to a total of usage of the respective gas $\times$ global warming potential of the respective gas. To calculate "$CO_2$ equivalent emissions", the global warming potential of $C_4F_8$ was defined as 9540 and the global warming potential of HFO-1234yf was defined as 1.

<Example 2-1>

With the plasma processing apparatus 100 illustrated in Fig. 1, a test was performed to form a hole having a diameter of 600 $\mu$m and a depth of 250 $\mu$m in a substrate S (Si substrate) by deep etching.

In the etching process step S2, conditions were as follows: etching step time (time required for one etching process) was 8.0 sec, the flow rate of supplied $SF_6$ was 400 sccm, the pressure in the chamber 1 was 20 Pa, the high frequency power applied to the coil 4 was 4000 W, and the high frequency power applied to the mounting table body 21 of the mounting table 2 was 60 W.

In the protective film deposition process step S3, conditions were as follows: protective film deposition step time (time required for one protective film deposition process) was 2.4 sec, the flow rate of supplied mixed gas was 250 sccm, the pressure in the chamber 1 was 15 Pa, and the high frequency power applied to the coil 4 was 3500 W. The condition of the flow rate ratio of HFO-1234yf in the mixed gas was 5%.

Under the above-described conditions, the etching process step S2 and the protective film deposition process step S3 were alternately and repeatedly executed until a hole having a depth of 250 $\mu$m was formed.

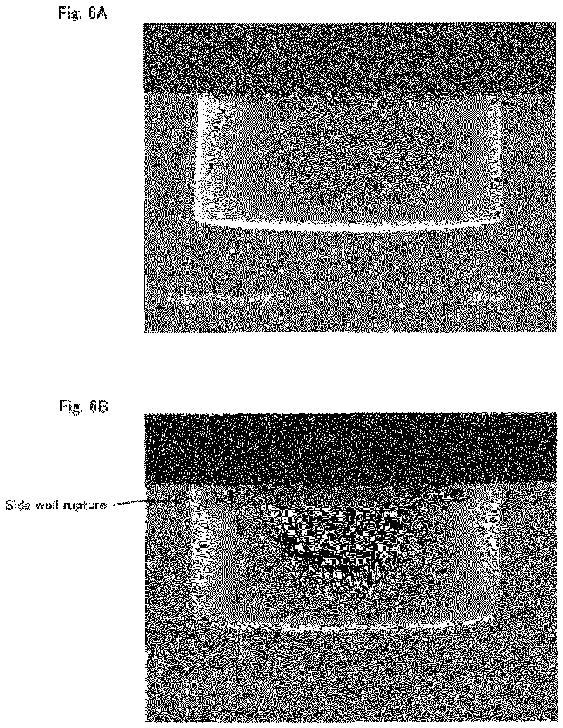

Figs. 6A and 6B are sectional SEM photographs illustrating example shapes of holes formed by deep etching. Fig. 6A illustrates an example shape of a hole in good shape, Fig. 6B illustrates an example shape of a hole suffering from a side wall rupture. Note that the hole illustrated in Fig. 6A corresponds to a hole formed in Example 2-1.

When the protective film deposition step time set in the protective film deposition process step S3 is too short, the thickness of the protective film deposited on a side wall of a hole (in particular, upper side wall) is reduced. As a result, in the etching process step S2, the side wall of the hole is etched due to an insufficient thickness of the protective film, leading to a side wall rupture as illustrated in Fig. 6B. On the other hand, when the protective film deposition step time set in the protective film deposition process step S3 is too long, the thickness of the protective film deposited on a bottom surface of the hole is increased. As a result, in the etching process step S2, the protective film deposited on a bottom surface of the hole is not sufficiently removed, leading to a residue (not illustrated). Accordingly, the protective film deposition step time set in the protective film deposition process step S3 was set to the shortest time without causing a side wall rupture as in the case of a trench.

In the cleaning process step S6, cleaning was executed for the cleaning time of 159.8 sec under the following conditions: the flow rate of supplied $O_2$ was 300 sccm, the pressure in the chamber 1 was 1 Pa, and the high frequency power applied to the coil 4 was 2500 W. As for the cleaning time, as in the case of a trench, when the elapsed time from the start of execution of the cleaning process step S6 to the end point X is defined as T0, the cleaning time $T = T0 + 0.5 \cdot T0 = 1.5T0$. In other words, 50% overcleaning was executed.

The etching process step S2 and the protective film deposition process step S3 described above are repeatedly executed on one substrate S, thereafter the chamber 1 is subjected to the cleaning process step S6, and then the result of evaluation of throughput was 4.34 wph.

In the evaluation of throughput, as in the case of trench, a time spent for executing the substrate mounting step S1 and the substrate retrieving step S5 is included.

In Example 2-1, although one substrate S was used to evaluate throughput, it is possible to evaluate time spent for performing a series of steps of the substrate mounting step S1 to the cleaning process step S6 for each of a plurality of substrates S, and evaluate the throughput from an average. Same applies to other Examples 2-2 to 2-4 and Comparative Examples 2-5, 2-6, 2-1, 2-2 described later.

<Example 2-2>

Except that the flow rate ratio of HFO-1234yf in the mixed gas used in the protective film deposition process step S3 was 20%, a hole was formed by executing deep etching under the same conditions as in Example 2-1 (setting of the protective film deposition step time and determination of the cleaning time were made in a similar way, although values may be different). The throughput was 4.51 wph.

<Example 2-3>

Except that the flow rate ratio of HFO-1234yf in the mixed gas used in the protective film deposition process step S3 was 50%, a hole was formed by executing deep etching under the same conditions as in Example 2-1 (setting of the protective film deposition step time and determination of the cleaning time were made in a similar way, although values may be different). The throughput was 4.46 wph.

<Example 2-4>

Except that the flow rate ratio of HFO-1234yf in the mixed gas used in the protective film deposition process step S3 was 60%, a hole was formed by executing deep etching under the same conditions as in Example 2-1 (setting of the protective film deposition step time and determination of the cleaning time were made in a similar way, although values may be different). The throughput was 4.34 wph.

<Comparative Example 2-5>

Except that the flow rate ratio of HFO-1234yf in the mixed gas used in the protective film deposition process step S3 was 80%, a hole was formed by executing deep etching under the same conditions as in Example 2-1 (setting of the protective film deposition step time and determination of the cleaning time were made in a similar way, although values may be different). The throughput was 4.17 wph.

<Comparative Example 2-6>

Except that the flow rate ratio of HFO-1234yf in the mixed gas used in the protective film deposition process step S3 was 95%, a hole was formed by executing deep etching under the same conditions as in Example 2-1 (setting of the protective film deposition step time and determination of the cleaning time were made in a similar way, although values may be different). The throughput was 3.85 wph.

<Comparative Example 2-1>

Except that the protective film deposition gas used in the protective film deposition process step S3 was $C_4F_8$ alone (in other words, the flow rate ratio of HFO-1234yf was 0%), a hole was formed by executing deep etching under the same conditions as in Example 2-1 (setting of the protective film deposition step time and determination of the cleaning time were made in a similar way, although values may be different). The throughput was 4.32 wph.

<Comparative Example 2-2>

Except that the protective film deposition gas used in the protective film deposition process step S3 was HFO-1234yf alone (in other words, the flow rate ratio of HFO-1234yf was 100%), a hole was formed by executing deep etching under the same conditions as in Example 2-1 (setting of the protective film deposition step time and determination of the cleaning time were made in a similar way, although values may be different). The throughput was 3.86 wph.

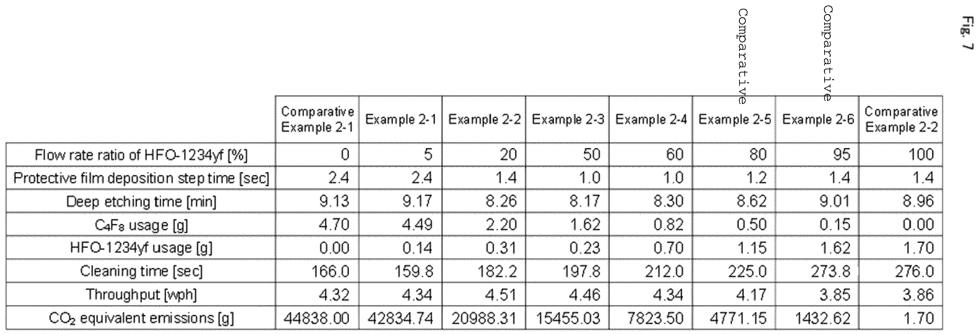

Fig. 7 illustrates primary test conditions and test results of Examples 2-1 to 2-4 and Comparative Examples 2-5, 2-6, 2-1, 2-2 as described above.
"Deep etching time" illustrated in Fig. 7 refers to time spent for forming a hole having a depth of 250 $\mu$m. "$C_4F_8$ usage" refers to a total usage of $C_4F_8$ used for forming the hole having a depth of 250 $\mu$m. "HFO-1234yf usage" refers to a total usage of HFO-1234yf used for forming the hole having a depth of 250 $\mu$m. "$CO_2$ equivalent emissions" refer to a total of usage of the respective gas $\times$ global warming potential of the respective gas. To calculate "$CO_2$ equivalent emissions", the global warming potential of $C_4F_8$ was defined as 9540 and the global warming potential of HFO-1234yf was defined as 1.

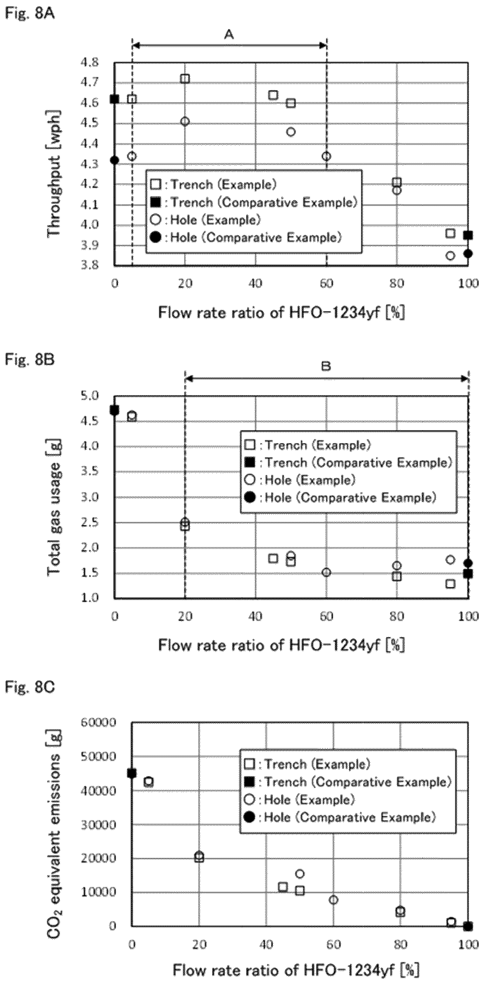

Figs. 8A, 8B, and 8C illustrate, based on test results of Examples 1-1 to to 1-4 and 2-1 to 2-4 and Comparative Examples 1-5, 1-6, 1-1, 102, 2-5, 2-6, 2-1, 2-2 as described above, a relationship between the flow rate ratio of HFO-1234yf and the throughput, a relationship between the flow rate ratio of HFO-1234yf and the total gas usage and a relationship between the flow rate ratio of HFO-1234yf and the $CO_2$ equivalent emissions in an ordered manner. Fig. 8A illustrates a relationship between the flow rate ratio of HFO-1234yf and the throughput in an ordered manner. Fig. 8B illustrates a relationship between the flow rate ratio of HFO-1234yf and the total gas usage in an ordered manner. Fig. 8C illustrates a relationship between the flow rate ratio of HFO-1234yf and the $CO_2$ equivalent emissions in an ordered manner. "□" and "■" in Figs. 8A, 8B, and 8C indicate data on a trench ("□" indicates the examples, "■" indicates the comparative examples). "O" and "●" in Figs. 8A, 8B, and 8C indicate data on a hole ("O" indicates the examples, "●" indicates the comparative examples).
As illustrated in Fig. 8A, it can be seen that when the flow rate ratio of HFO-1234yf is 5% or more and 60% or less (within the range A illustrated in Fig. 8A), high-throughput plasma processing can be achieved, the throughput being equivalent to, or higher, as compared not only to the case of using HFO-1234yf as a protective film deposition gas (the flow rate ratio of HFO-1234yf = 100%), but also to the case of using $C_4F_8$ (the flow rate ratio of HFO-1234yf = 0%). It can be seen that, more preferably, when the flow rate ratio of HFO-1234yf is 5% or more and 45% or less, higher throughput plasma processing can be achieved than the case of using $C_4F_8$ as a protective film deposition gas (the flow rate ratio of HFO-1234yf = 0%).
"Total gas usage" illustrated in Fig. 8B refers to a total of usage of $C_4F_8$ and HFO-1234yf used for forming a trench or a hole having a depth of 250 $\mu$m.
As illustrated in Fig. 8B, it can be seen that when the flow rate ratio of HFO-1234yf is 20% or more and less than 100% (within the range B illustrated in Fig. 8B), gas usage required for obtaining a predetermined etching depth can be more reduced as compared to the case of using $C_4F_8$ as a protective film deposition gas (the flow rate ratio of HFO-1234yf = 0%).
As illustrated in Fig. 8C, it can be seen that the larger the flow rate ratio of HFO-1234yf is, the smaller the $CO_2$ equivalent emissions are, so that impacts on global warming can be suppressed.
It can be seen from the results described above that, more preferably, the flow rate ratio of HFO-1234yf can be 20% or more and 60% or less (most preferably, 20% or more and 45% or less) to achieve plasma processing with which impacts on global warming are suppressed, the throughput is high, and the gas usage is small.
In Examples 1-1 to 1-4 and Examples 2-1 to 2-4, conditions in each of repeatedly executed protective film deposition processes S3: the protective film deposition step time; the flow rate ratio of HFO-1234yf in the mixed gas; and the flow rate of the mixed gas, have been set to fixed values. However, the present invention is not limited thereto, and at least one of the protective film deposition step time, the flow rate ratio of HFO-1234yf in the mixed gas, and the flow rate of the mixed gas may have a different value set thereto for each protective film deposition process step S3. It is also possible to change the flow rate ratio of HFO-1234yf in the mixed gas and/or the flow rate of the mixed gas during one protective film deposition process S3 (in other words, for several seconds of a protective film deposition step time). In this way, it is possible to improve flexibility in process optimization.

[Reference Signs List]

| | |
|---|---|
| 1 | chamber |
| 2 | mounting table |
| 3, 3a, 3b, 3c, 3d | gas supply source |
| 4 | coil |
| 5, 7 | high frequency power supply |
| 6, 8 | impedance matching device |
| 9 | lifting device |
| 9a | lift pins |
| 10 | exhaust device |
| S | substrate |

**Claims**

1. A plasma processing method of subjecting a substrate (S) to deep etching by executing alternately and repeatedly an etching process of etching the substrate (S) by using plasma generated in a chamber (1) and a protective film deposition process of depositing a protective film in a recess formed through the etching process by using plasma generated in the chamber (1),

   wherein in the protective film deposition process, a plasma processing gas which is a mixed gas of $C_4F_8$ and 2,3,3,3-tetrafluoropropene and has a flow rate ratio of 2,3,3,3-tetrafluoropropene in the mixed gas being 5% or more and 60% or less is used as gas supplied for generating plasma, and
   wherein after completion of the deep etching on the substrate (S), a cleaning process step (S6) is executed to clean the chamber (1).

2. The plasma processing method according to claim 1, wherein the flow rate ratio of 2,3,3,3-tetrafluoropropene in the mixed gas is 20% or more and 60% or less.

3. The plasma processing method according to claim 1 or claim 2,

   wherein in the cleaning process step (S6), the chamber is cleaned by turning gas containing $O_2$ into plasma and emission intensity of CO in the chamber (1) is measured, and
   wherein when a point at which an absolute value of a rate of change of the emission intensity of CO reaches 1% or less is defined as an end point X and an elapsed time from start of execution of the cleaning process step (S6) to the end point X is defined as T0, a cleaning time T in the cleaning process step is determined by the following formula.

$$T=1.5T0$$

**Patentansprüche**

1. Plasmaverarbeitungsverfahren, bei dem ein Substrat (S) durch abwechselndes und wiederholtes Ausführen eines Ätzprozesses zum Ätzen des Substrats (S) durch Verwenden eines in einer Kammer (1) erzeugten Plasmas und eines Schutzfilmabscheidungsprozesses zum Abscheiden eines Schutzfilms in einer durch den Ätzprozess ausgebildeten Vertiefung durch Verwenden des in der Kammer (1) erzeugten Plasmas einer Tiefenätzung unterzogen wird,

   wobei in dem Schutzfilmabscheidungsprozess ein Plasmaverarbeitungsgas, das ein Mischgas aus $C_4F_8$ und 2,3,3,3-Tetrafluorpropen ist und ein Strömungsverhältnis von 2,3,3,3-Tetrafluorpropen in dem Mischgas von 5 % oder mehr und 60 % oder weniger aufweist, als Gas verwendet wird, das für eine Plasmaerzeugung zugeführt wird, und
   wobei nach Abschluss des Tiefenätzens auf dem Substrat (S) ein Reinigungsprozessschritt (S6) ausgeführt wird, um die Kammer (1) zu reinigen.

2. Plasmaverarbeitungsverfahren nach Anspruch 1, wobei das Strömungsverhältnis von 2,3,3,3-Tetrafluorpropen in dem Mischgas 20 % oder mehr und 60 % oder weniger beträgt.

3. Plasmaverarbeitungsverfahren nach Anspruch 1 oder 2,
   wobei in dem Reinigungsschritt (S6) die Kammer durch Umwandeln von $O_2$ enthaltendem Gas in Plasma gereinigt wird und eine Emissionsintensität von CO in der Kammer (1) gemessen wird, und wobei, wenn ein Punkt, an dem ein absoluter Wert einer Änderungsrate der Emissionsintensität von CO 1 % oder weniger erreicht, als Endpunkt X definiert wird und eine verstrichene Zeit von einem Beginn der Ausführung des Reinigungsprozessschritts (S6) bis zu dem Endpunkt X als T0 definiert wird, eine Reinigungszeit T in dem Reinigungsprozessschritt durch die folgende Formel bestimmt wird.

$$T = 1,5T0$$

## Revendications

1. Procédé de traitement de plasma consistant à soumettre un substrat (S) à une gravure profonde en exécutant alternativement et de manière répétée un processus de gravure du substrat (S) à l'aide d'un plasma généré dans une chambre (1) et un processus de dépôt de film protecteur consistant à déposer un film protecteur dans une cavité formée par le processus de gravure à l'aide d'un plasma généré dans la chambre (1),

   dans lequel, dans le processus de dépôt de film protecteur, un gaz de traitement de plasma qui est un gaz mélangé de $C_4F_8$ et de 2,3,3,3-tétrafluoropropène et dont le rapport de débit du 2,3,3,3-tétrafluoropropène dans le gaz mélangé est supérieur ou égal à 5 % et inférieur ou égal à 60 % est utilisé comme gaz fourni pour générer du plasma, et
   dans lequel, après l'achèvement de la gravure profonde sur le substrat (S), une étape de processus de nettoyage (S6) est exécutée pour nettoyer la chambre (1).

2. Procédé de traitement de plasma selon la revendication 1, dans lequel le rapport de débit du 2,3,3,3-tétrafluoropropène dans le gaz mélangé est supérieur ou égal à 20 % et inférieur ou égal à 60 %.

3. Procédé de traitement de plasma selon la revendication 1 ou la revendication 2,
   dans lequel, lors de l'étape de processus de nettoyage (S6), la chambre est nettoyée en transformant le gaz contenant de l'$O_2$ en plasma et l'intensité d'émission de CO dans la chambre (1) est mesurée, et dans lequel, lorsqu'un point auquel une valeur absolue d'un taux de variation de l'intensité d'émission de CO atteint 1 % ou moins est défini comme un point final X et qu'un temps écoulé entre le début de l'exécution de l'étape de processus de nettoyage (S6) et le point final X est défini comme T0, un temps de nettoyage T dans l'étape de processus de nettoyage est déterminé par la formule suivante.

$$T = 1,5T0$$

Fig. 1

Fig. 2

Start

Substrate mounting step — S1

Etching process step — S2

Protective film deposition process step — S3

No ← Does recess reach preset depth? — S4

Yes

Substrate retrieving step — S5

Cleaning process step — S6

Yes ← Is there another substrate? — S7

No

End

Fig. 3A

Fig. 3B

Fig. 3C

Fig. 4

Emission intensity of CO (wavelength 483 nm)

Fig. 5

| | Comparative Example 1-1 | Example 1-1 | Example 1-2 | Example 1-3 | Example 1-4 | Comparative Example 1-5 | Comparative Example 1-6 | Comparative Example 1-2 |
|---|---|---|---|---|---|---|---|---|
| Flow rate ratio of HFO-1234yf [%] | 0 | 5 | 20 | 45 | 50 | 80 | 95 | 100 |
| Protective film deposition step time [sec] | 2.2 | 2.2 | 1.2 | 1.0 | 1.0 | 1.0 | 1.0 | 1.2 |
| Deep etching time [min] | 8.67 | 8.67 | 8.38 | 8.30 | 8.23 | 8.17 | 8.23 | 8.26 |
| $C_4F_8$ usage [g] | 4.73 | 4.45 | 2.13 | 1.22 | 1.10 | 0.44 | 0.11 | 0.00 |
| HFO-1234yf usage [g] | 0.00 | 0.14 | 0.30 | 0.57 | 0.63 | 1.00 | 1.18 | 1.49 |
| Cleaning time [sec] | 138.8 | 138.0 | 139.8 | 158.6 | 168.2 | 246.0 | 296.0 | 296.7 |
| Throughput [wph] | 4.62 | 4.62 | 4.72 | 4.64 | 4.60 | 4.21 | 3.96 | 3.95 |
| $CO_2$ equivalent emissions [g] | 45124.20 | 42453.14 | 20320.50 | 11639.37 | 10494.63 | 4198.60 | 1050.58 | 1.49 |

Fig. 6A

Fig. 6B

Side wall rupture

Fig. 7

| | Comparative Example 2-1 | Example 2-1 | Example 2-2 | Example 2-3 | Example 2-4 | Comparative Example 2-5 | Comparative Example 2-6 | Comparative Example 2-2 |
|---|---|---|---|---|---|---|---|---|
| Flow rate ratio of HFO-1234yf [%] | 0 | 5 | 20 | 50 | 60 | 80 | 95 | 100 |
| Protective film deposition step time [sec] | 2.4 | 2.4 | 1.4 | 1.0 | 1.0 | 1.2 | 1.4 | 1.4 |
| Deep etching time [min] | 9.13 | 9.17 | 8.26 | 8.17 | 8.30 | 8.62 | 9.01 | 8.96 |
| $C_4F_8$ usage [g] | 4.70 | 4.49 | 2.20 | 1.62 | 0.82 | 0.50 | 0.15 | 0.00 |
| HFO-1234yf usage [g] | 0.00 | 0.14 | 0.31 | 0.23 | 0.70 | 1.15 | 1.62 | 1.70 |
| Cleaning time [sec] | 166.0 | 159.8 | 182.2 | 197.8 | 212.0 | 225.0 | 273.8 | 276.0 |
| Throughput [wph] | 4.32 | 4.34 | 4.51 | 4.46 | 4.34 | 4.17 | 3.85 | 3.86 |
| $CO_2$ equivalent emissions [g] | 44838.00 | 42834.74 | 20988.31 | 15455.03 | 7823.50 | 4771.15 | 1432.62 | 1.70 |

Fig. 8A

Fig. 8B

Fig. 8C

**EP 4 167 272 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016171323 A
- JP 2011124239 A
- JP 6529943 B
- JP 6438511 B